# EUROPEAN PATENT APPLICATION

(11) **EP 4 580 365 A1**
(43) Date of publication of application: **02.07.2025**
(21) Application number: 24195657.2
(22) Date of filing: 21.08.2024
(51) Int. Cl.: H10K 59/122

(54) **DISPLAY DEVICE**

(30) Priority: 26.12.2023 KR 20230191382
(71) Applicant: LG Display Co., Ltd., Seoul 07336 (KR)
(72) Inventor: HWANG, Soo-Won, 10845 Gyeonggi-do (KR)
(74) Representative: Ter Meer Steinmeister & Partner

(57) **Abstract**

A display device in one example includes a first bank disposed on a planarization layer in a non-emitting area and a first electrode disposed on the planarization layer in an emitting area. A trench is disposed in an upper surface of the first bank, and the first electrode extends to the upper surface of the first bank and is disposed in the trench. Accordingly, a damage to a light emitting device caused by an outgas may be prevented.

## Description

This application claims priority to Korean Patent Application No. 10-2023-0191382 filed in the Republic of Korea on December 26, 2023.

### BACKGROUND

### Field of the Invention

The present disclosure relates to a display device capable of preventing damage to a light emitting device which can be caused by an outgas.

### Description of the Related Art

A display device is widely used as a display screen of a notebook computer, a tablet computer, a smart phone, a portable display device, and a portable information device in addition to a display screen of a television or a monitor. With the advancement of technology, the display device may provide photographing or various sensing functions in addition to an image display function. Accordingly, the display device needs to include an electronic device such as a camera or a sensor.

Among the display devices, an organic light emitting display device is a self-emission type, and has advantages such as superior viewing angle and contrast ratio compared to a liquid crystal display (LCD). Further, in the organic light emitting display device, light weight and thinness can be achieved because no separate backlight is required, and thus, power consumption can be advantageously reduced. In addition, the organic light emitting display device has the advantage of being able to drive DC low voltage, fast response speed, and especially low manufacturing cost.

Recently, in order to improve a reflective visibility of the display device, a black bank including a material that absorbs light is used. In this case, an outgas can be generated in a process of forming the black bank. The outgas generated in the black bank can penetrate an adjacent light emitting device and damage the light emitting device. In particular, the outgas can penetrate into a boundary area between an anode and a light emitting layer associated with the light emitting device. Accordingly, a dark spot can occur in a pixel in which the damaged light emitting device is disposed, and reliability of the display device can be reduced or deteriorated.

### SUMMARY

The present disclosure has been made in view of the above limitations associated with the related art, and it is an object of the present disclosure to provide a display device capable of preventing damage to a light emitting device which can be caused by an outgas.

The object is solved by the features of the independent claims. Preferred embodiments are given in the dependent claims.

In accordance with an aspect of the present disclosure, the above and other objects can be accomplished by the provision of a display device comprising a substrate on which a plurality of sub-pixels are disposed, the plurality of sub-pixels including a emitting area and a non-emitting area surrounding the emitting area, a planarization layer disposed in the emitting area and the non-emitting area, a first bank disposed on the planarization layer in the non-emitting area, a first electrode disposed on the planarization layer in the emitting area, and a second bank disposed on the first bank, wherein a trench is disposed in an upper surface of the first bank, and the first electrode extends to the upper surface of the first bank and is disposed in the trench.

In addition, in accordance with an aspect of the present disclosure, the above and other objects can be accomplished by the provision of a display device comprising a substrate in which a plurality of sub-pixels are disposed, the plurality of sub-pixels including a emitting area and a non-emitting area surrounding the emitting area, a planarization layer disposed in the emitting area and the non-emitting area, a first bank disposed on the planarization layer in the non-emitting area, a first electrode disposed on the planarization layer in the emitting area, a protective layer disposed on the first bank and a second bank disposed on the protective layer, wherein a trench is disposed in an upper surface of the first bank and the protective layer is disposed in the trench.

In addition, in accordance with an aspect of the present disclosure, the above and other objects can be accomplished by the provision of a display device comprising a substrate in which a plurality of sub-pixels are disposed, the plurality of sub-pixels including an emitting area and a non-emitting area surrounding the emitting area, a bank disposed in the non-emitting area, and a first electrode disposed in the emitting area, wherein the bank includes a trench surrounding the emitting area of each of the plurality of sub-pixels.

In the following optional features are provided which can be combined with any one of the preceding aspects of the disclosure alone or in combination or sub combination.

In one or more embodiments, the first electrode may cover a part of one side surface of the trench.

In one or more embodiments, the first electrode may cover the entire one side surface of the trench and may extend to a lower surface of the trench.

In one or more embodiments, the first electrode may be disposed between the first and second banks in the non-emitting area.

In one or more embodiments, the trench may expose a part of an upper surface of the planarization layer.

In one or more embodiments, the first bank may expose an upper surface of the planarization layer corresponding to the emitting area.

In one or more embodiments, the first electrode may extend to an upper surface of the first bank from the upper surface of the planarization layer corresponding to the emitting area.

In one or more embodiments, an end of the first electrode may be in contact with an end of the protective layer on the upper surface of the first bank.

In one or more embodiments, the first electrode may cover a partial area of the upper surface of the first bank.

In one or more embodiments, the protective layer may cover a remaining area of the upper surface of the first bank.

In one or more embodiments, the protective layer may cover a part of one side surface of the trench.

In one or more embodiments, the protective layer may cover an entire one side surface of the trench and extends to a lower surface of the trench.

In one or more embodiments, the plurality of sub-pixels may include a first sub-pixel and a second sub-pixel adjacent to each other.

In one or more embodiments, the trench disposed in the first sub-pixel may be spaced apart from the trench disposed in the second sub-pixel.

In one or more embodiments, the plurality of sub-pixels may include a first sub-pixel and a second sub-pixel adjacent to each other.

In one or more embodiments, the trench may be disposed in a boundary area between the first and second sub-pixels.

In one or more embodiments, the first electrode may extend to the non-emitting area between the emitting area and the trench from the emitting area.

In one or more embodiments, the first electrode may overlap the trench.

In one or more embodiments, the display device may further comprise a protective layer surrounding the first electrode .

In one or more embodiments, the protective layer may be in contact with an edge of the first electrode.

In one or more embodiments, the protective layer may be disposed in the non-emitting area between the edge of the first electrode and the trench, and overlaps the trench.

In one or more embodiments, the display device may further comprise a protective layer disposed in a boundary area between the first and second sub-pixels.

In one or more embodiments, the protective layer may overlap the trench.

In one or more embodiments, the bank may be a black bank.

In one or more embodiments, the protective layer may include an inorganic insulating material.

In one or more embodiments, the protective layer may further include a material that absorbs moisture.

### BRIEF DESCRIPTION OF THE DRAWINGS

The present disclosure will become more fully understood from the detailed description given hereinbelow and the accompanying drawings which are given by way of illustration only, and thus are not limitative of the present disclosure.
FIG. 1 is a plan view of a display device according to an embodiment of the present disclosure.
FIGS. 2 and 3 are plan views of one pixel of a display device according to an embodiment of the present disclosure.
FIG. 4 is a cross-sectional view of a sub-pixel of a display device according to a first embodiment of the present disclosure.
FIG. 5 is a cross-sectional view of a modified example of a sub-pixel of the display device according to the first embodiment of the present disclosure.
FIG. 6 is a cross-sectional view of a sub-pixel of a display device according to a second embodiment of the present disclosure.
FIG. 7 is a plan view of one pixel of a display device according to another embodiment of the present disclosure.
FIG. 8 is a plan view of one pixel of a display device according to another embodiment of the present disclosure.
FIG. 9 is a cross-sectional view of a sub-pixel of a display device according to a third embodiment of the present disclosure.
FIG. 10 is a cross-sectional view of a sub-pixel of a display device according to a fourth embodiment of the present disclosure.
FIG. 11 is a cross-sectional view of a sub-pixel of a display device according to a fifth embodiment of the present disclosure.

### DETAILED DESCRIPTION OF THE DISCLOSURE

Advantages and features of the present disclosure and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete and will fully convey the scope of the present disclosure to those skilled in the art.

A shape, a size, a ratio, an angle and a number disclosed in the drawings for describing embodiments of the present disclosure are merely an example and thus, the present disclosure is not limited to the illustrated details. Like reference numerals refer to like elements throughout the specification. In the following description, when the detailed description of the relevant known function or configuration is determined to unnecessarily obscure the important point of the present disclosure, the detailed description may be omitted or may be briefly provided. In a case where 'comprise', 'have' and 'include' described in the present disclosure are used, another portion can be added unless 'only' is used.

In construing an element, the element is construed as including an error band although there is no explicit description.

In describing a position relationship, for example, when the position relationship is described as 'upon', 'above', 'below' and `next to', one or more portions can be disposed between two other portions unless `just' or 'direct' is used.

It will be understood that, although the terms "first," "second," etc. can be used herein to describe various elements, these elements should not be limited by these terms. These terms are only used to distinguish one element from another. For example, a first element could be termed a second element, and, similarly, a second element could be termed a first element, without departing from the scope of the present disclosure.

Features of various embodiments of the present disclosure can be partially or overall coupled to or combined with each other and can be variously inter-operated with each other and driven technically as those skilled in the art can sufficiently understand. The embodiments of the present disclosure can be carried out independently from each other or can be carried out together in a co-dependent relationship.

Hereinafter, the preferred embodiments of the present disclosure will be described in detail with reference to the accompanying drawings. All the components of each display device according to all embodiments of the present disclosure are operatively coupled and configured.

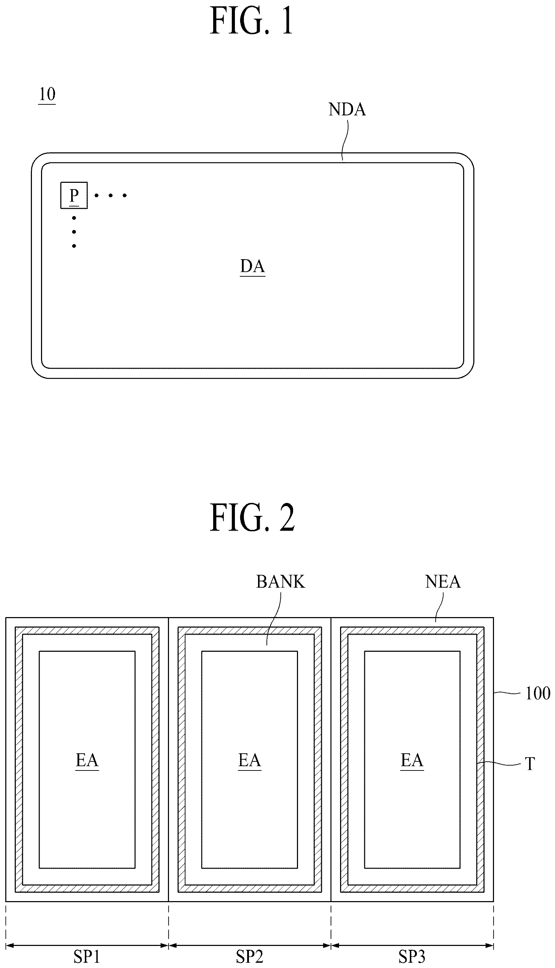

FIG. 1 is a plan view of a display device 10 according to an embodiment of the present disclosure.

Referring to FIG. 1, the display device 10 according to the embodiment of the present disclosure can include a display area DA and a non-display area NDA surrounding or adjacent to the display area DA. The display area DA is an area in which an image can be displayed, and the non-display area NDA is an area in which an image is not or may not be displayed.

The display area DA can include a plurality of pixels P. The plurality of pixels P can be arranged in a matrix form composed of a plurality of rows and columns. However, other arrangements are possible. Also, the non-display area NDA can include a plurality of wirings, pads, driving circuits, and the like for driving the plurality of pixels P.

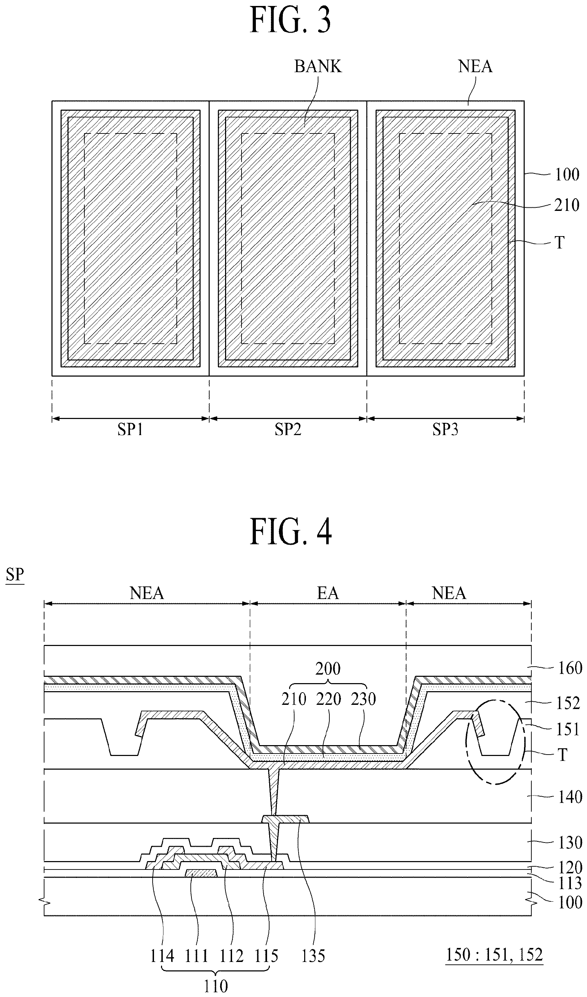

FIGS. 2 and 3 are plan views of one pixel P of a display device according to an embodiment of the present disclosure. The display device can include pixels P, each having the configuration of FIGS. 2 and3.

Referring to FIGS. 2 and 3, one pixel P can include a first sub-pixel SP1, a second sub-pixel SP2 and a third sub-pixel SP3. The first sub-pixel SP1, the second sub-pixel SP2 and the third sub-pixel SP3 can emit light different from each other. For example, the first sub-pixel SP1 can emit red light, the second sub-pixel SP2 can emit green light, and the third sub-pixel SP3 can emit blue light, but is not limited thereto. Also, although FIG. 2 shows that one pixel P includes three sub-pixels SP1 to SP3, the configuration of one pixel P is not limited thereto, and one pixel P can include more sub-pixels.

Each of the first subpixel SP1, the second subpixel SP2, and the third subpixel SP3 is disposed on the substrate 100 and can include an emitting area EA and a non-emitting area NEA surrounding or adjacent to the emitting area EA. The emitting area EA is an area capable of emitting light, and the non-emitting area NEA is an area that does not emit light.

Referring to FIG. 2, a bank BANK can be disposed on the substrate 100. The bank BANK can be disposed in the non-emitting area NEA and can surround each of the first subpixel SP1, the second subpixel SP2, and the third subpixel SP3.

The bank BANK can include a trench T. The trench T can be formed by removing a partial region of the bank BANK from the substrate 100. The trench T can have a ring shape surrounding each of the emitting areas EA of the first to third sub-pixels SP1 to SP3. For example, the trenches T disposed in each sub-pixel SP can be spaced apart from each other in a boundary area of two adjacent sub-pixels SP.

Referring to FIG. 3, a first electrode 210 can be disposed on the substrate 100. The first electrode 210 can be disposed in each of the first to third sub-pixels SP1 to SP3. In one sub-pixel SP, the first electrode 210 can be disposed in the emitting area EA. Also, the first electrodes 210 disposed in each of the first to third sub-pixels SP1 to SP3 can be spaced apart from each other.

The first electrode 210 can extend from the emitting area EA and can also be disposed in a part of the non-emitting area NEA. Specifically, in one sub-pixel SP, the first electrode 210 can be disposed in the non-emitting area NEA between the emitting area EA and the trench T. For example, the first electrode 210 can be disposed inside the area surrounded by the trench T. Also, the first electrode 210 can overlap the trench T.

The first electrode 210 can include a transparent conductive material such as an indium tin oxide (ITO) or an indium zinc oxide (IZO). Alternatively, the first electrode 210 can include a metal material such as aluminum (Al), silver (Ag), copper (Cu), molybdenum (Mo), titanium (Ti), tungsten (W), or chromium (Cr), or an alloy thereof. Also, although illustrated as a single layer, the first electrode 210 can be formed of multiple layers.

FIG. 4 is a cross-sectional view of a sub-pixel SP of a display device according to a first embodiment of the present disclosure. FIG. 4 is a cross-sectional view of any one of the plurality of sub-pixels shown in FIGS. 2 and 3. The display device can include sub-pixels SP, each having the configuration of FIG. 4.

Referring to FIG. 4, one sub-pixel SP according to an embodiment of the present disclosure can include a substrate 100, a thin film transistor 110, a passivation layer 120, a first planarization layer 130, a connection electrode 135, a second planarization layer 140, a bank 150, an encapsulation layer 160, and a light emitting device 200.

The substrate 100 can be formed of glass or plastic, but is not limited thereto. The display device according to an embodiment of the present disclosure can be configured in a top emission type in which the emitted light is emitted upward. Therefore, as the material of the substrate 100, not only a transparent material but also an opaque material can be used.

The thin film transistor 110 can be disposed on the substrate 100. The thin film transistor 110 can include a gate electrode 111, a semiconductor layer 112, a gate insulating layer 113, a source electrode 114, and a drain electrode 115.

The gate electrode 111 of the thin film transistor 110 can be disposed on the substrate 100. Also, the semiconductor layer 112 can be disposed on the gate electrode 111. The semiconductor layer 112 can include a poly-silicon semiconductor or an oxide semiconductor. In addition, when the semiconductor layer 112 includes an oxide semiconductor, at least one oxide of indium-gallium-zinc-oxide (IGZO), indium-zinc-oxide (IZO), indium-gallium-tin-oxide (IGTO), and indium-gallium-oxide (IGO) can be included.

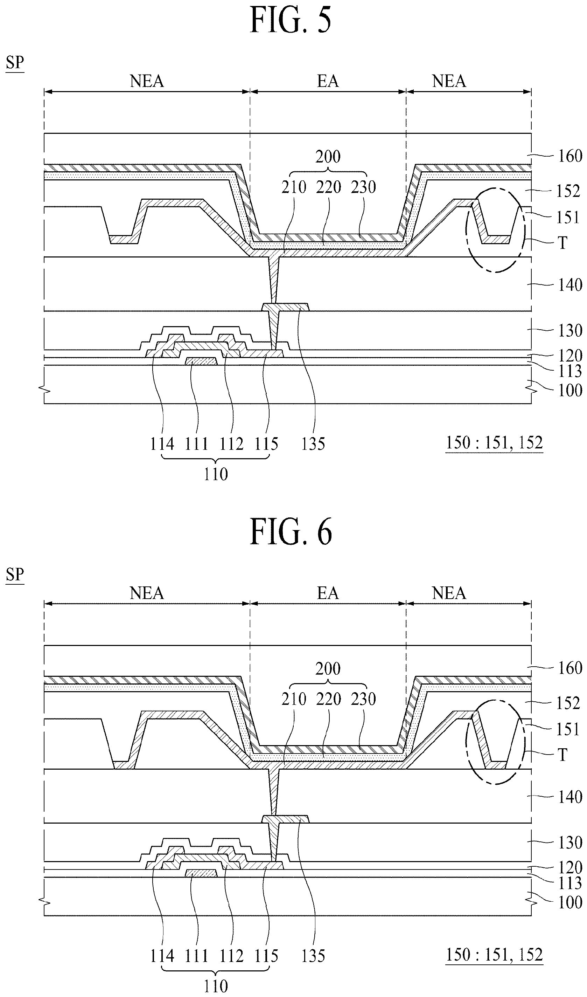

To insulate the gate electrode 111 from the semiconductor layer 112, a gate insulating layer 113 can be disposed between the gate electrode 111 and the semiconductor layer 112. The gate insulating layer 113 can include a single layer of silicon nitride (SiNx) or silicon oxide (SiOx) or multiple layers thereof. Also, FIG. 5 illustrates a bottom gate structure in which a semiconductor layer 112 is disposed on a gate electrode 111, but is not limited thereto. For example, a top gate structure in which the gate electrode 111 is disposed on the semiconductor layer 112 can be disclosed.

The source electrode 114 and the drain electrode 115 can be disposed on the semiconductor layer 112 while facing each other. Also, the passivation layer 120 can be disposed on the source electrode 114 and the drain electrode 115. A contact hole exposing a portion of the drain electrode 115 can be formed in the passivation layer 120. Also, the passivation layer 120 can be formed of an inorganic insulating material, such as silicon oxide (SiOx), silicon nitride (SiNx), silicon oxynitride (SiOxNy).

The first planarization layer 130 can be disposed on the thin film transistor 110, and the second planarization layer 140 can be disposed on the first planarization layer 130. The first and second planarization layers 130 and 140 can compensate for a step difference caused by the thin film transistor 110 to planarize an upper region of the thin film transistor 110. Furthermore, the first and second planarization layers 130 and 140 can be formed of an organic insulating material such as an acrylic resin, an epoxy resin, a phenolic resin, a polyamide resin, or a polyimide resin.

The bank 150 can be disposed on the second planarization layer 140 and can be disposed in the non-emitting area NEA. Also, the bank 150 can include a first bank 151 and a second bank 152.

The first bank 151 can be disposed on the second planarization layer 140. Since the first bank 151 is disposed in the non-emitting area NEA, the first bank 151 can expose an upper surface of the first planarization layer 140 corresponding to the emitting area EA. For example, an end of the first bank 151 can be disposed in a boundary area between the emitting area EA and the non-emitting area NEA. Also, a side surface of the first bank 151 can have a slope.

A trench T can be disposed in an upper surface of the first bank 151. As described in FIGS. 3 and 4, the trench T can surround the emitting area EA. The trench T can be formed by etching a partial region of the first bank 151. The depth of the trench T can be less than the distance between the flat upper and lower surfaces of the first bank 151. For example, the trench T may not expose the second planarization layer 140 disposed on the lower surface of the first bank 151. a side surface and a lower surface of the trench T can be formed of a first bank 151.

The second bank 152 can be disposed on the first bank 151. Also, the second bank 152 can fill an inside of the trench T of the first bank 151. Like the first bank 151, since the second bank 152 is disposed in the non-emitting area NEA, the second bank 152 can expose the upper surface of the planarization layer 140 corresponding to the emitting area NEA. For example, an end of the second bank 152 can be disposed in the boundary area between the emitting area EA and the non-emitting area NEA. Also, the second bank 152 can cover a side surface of the first bank 151. A side surface of the second bank 152 can have a slope. An angle formed by the side surface of the second bank 152 and the substrate 100 can be greater than an angle formed by the side surface of the first bank 151 and the substrate 100.

The first and second banks 151 and 152 can include an organic insulating material such as an acrylic resin, an epoxy resin, a phenolic resin, a polyamide resin, a polyimide resin, etc. Alternatively, the first and second banks 151 and 152 can include an inorganic insulating material such as silicon oxide (SiOx), silicon nitride (SiNx), silicon oxynitride (SiOxNy), etc. In this case, the first bank 151 can further include a material that absorbs light. For example, the first bank 151 can be a black bank, and the second bank 152 can be a transparent bank.

The light emitting device 200 can be disposed on the second planarization layer 140. The light emitting device 200 can include a first electrode 210, a light emitting layer 220, and a second electrode 230.

The first electrode 210 is disposed on the second planarization layer 140 and can function as an anode of the display device. The first electrode 210 can be electrically connected with the drain electrode 115 of the thin film transistor 110 through the connection electrode 135 disposed on the first planarization layer 130.

The first electrode 210 can extend on the second planarization layer 140 exposed by the first and second banks 151 and 152 and can also be disposed on the upper surface of the first bank 151. For example, the first electrode 210 can be disposed in the emitting area EA and the non-emitting area NEA. In detail, an area of the first electrode 210 corresponding to the emitting area EA can be disposed on the upper surface of the second planarization layer 140, and an area of the first electrode 210 corresponding to the non-emitting area NEA can be disposed between the first and second banks 151 and 152.

The first electrode 210 can extend on the first bank 151 to the inside of the trench T. For example, referring to FIG. 4, the first electrode 210 can extend to a part of any one of the two side surfaces of the trench T, but is not limited thereto. The side surface of the trench T on which the first electrode 210 disposed can be a side surface of the two side surfaces of the trench T adjacent to the emitting area EA. For example, referring to FIG. 5, the first electrode 210 can cover the entire one side surface of the trench T and can extend to a part of the lower surface of the trench T.

The first electrode 210 can include a transparent conductive material such as an indium tin oxide (ITO) or an indium zinc oxide (IZO). Alternatively, the first electrode 210 can include a metal material such as aluminum (Al), silver (Ag), copper (Cu), molybdenum (Mo), titanium (Ti), tungsten (W), or chromium (Cr), or an alloy thereof. Also, although illustrated as a single layer, the first electrode 210 can be formed of multiple layers.

The light emitting layer 220 can be disposed on the first electrode 210 and the second bank 152. For example, the light emitting layer 220 can also be disposed in the emitting area EA and the non-emitting area NEA. In detail, an area of the light emitting layer 220 corresponding to the emitting area EA can be disposed on the upper surface of the first electrode 210, and an area of the light emitting layer 220 corresponding to the non-emitting area NEA can be disposed on the upper surface of the second bank 152.

The light emitting layer 220 can include a hole transporting layer, an organic emission layer, and an electron transporting layer. In this case, when a voltage is applied to the first electrode 210 and the second electrode 230, holes and electrons move to the organic emission layer through the hole transport layer and the electron transport layer, respectively, and can be combined with each other in the organic emission layer to emit light.

The second electrode 230 can be disposed on the light emitting layer 220. The second electrode 230 can function as a cathode of the display device. Like the light emitting layer 220, the second electrode 230 can be disposed in the emitting area EA and the non-emitting area NEA.

Since the display device according to an embodiment of the present disclosure is configured in a top emission type, the second electrode 230 can include a transparent conductive material such as an indium tin oxide (ITO) or an indium zinc oxide (IZO) to transmit the light emitted from the light emitting layer 220 upward.

The encapsulation layer 160 can be disposed on the light emitting device 200. The encapsulation layer 160 can include an organic insulating material such as an acrylic resin, an epoxy resin, a phenolic resin, a polyamide resin, or a polyimide resin.

In conclusion, the first embodiment of the present disclosure discloses a structure in which the first electrode 210 is disposed between the first and second banks 151 and 152 and the first electrode 210 is extended to the inside of the trench T of the first bank 151.

Typically, in the process of forming a black bank including the material absorbing light, the outgas can be generated. In this case, when the outgas penetrates into the light emitting device, the light emitting device can be damaged.

When the black bank is disposed on the anode, since the black bank is adjacent to a boundary area between the anode and the light emitting layer, the outgas can penetrate into the boundary area between the anode and the light emitting layer.

On the other hand, the first embodiment of the present disclosure discloses a structure in which the first bank 151 is disposed on the second planarization layer 140 and the first electrode 210 is disposed on the first bank 151. Accordingly, since the first electrode 210 covers the upper surface and the side surface of the first bank 151, the boundary area between the first electrode 210 and the light emitting layer 220 and the first bank 151 can be spaced apart from each other. Accordingly, it is possible to prevent the outgas generated in the first bank 151 from penetrating into the boundary area between the first electrode 210 and the light emitting layer 220.

In addition, the first embodiment of the present disclosure discloses a structure in which the trench T is disposed in the first bank 151 and the first electrode 210 extends to the inside of the trench T. Accordingly, a path in which the outgas generated in the first bank 151 moves to the boundary area between the first electrode 210 and the light emitting layer 220 can be further increased. Accordingly, the outgas generated in the first bank 151 can be further prevented from penetrating into the boundary area between the first electrode 210 and the light emitting layer 220.

FIG. 6 is a cross-sectional view of a sub-pixel SP of a display device according to a second embodiment of the present disclosure. The display device can include sub-pixels SP, each having the configuration of FIG. 6.

Compared with FIG. 4, FIG. 6 discloses substantially the same structure except for the structures of the trench T and the first electrode 210. Accordingly, the same reference numerals are used for the components that are the same as those of the sub-pixel SP shown in FIG. 4, and repeated descriptions are omitted or are briefly provided.

Like FIG. 4, FIG. 6 discloses the trench T disposed in a first bank 151. In this case, FIG. 4 discloses a structure in which the first bank 151 covers the second planarization layer 140 below the trench T, but FIG. 6 discloses a structure in which the trench T exposes a part of the second planarization layer 140. For example, the depth of the trench T can be the same as the distance between the flat upper and lower surfaces of the first bank 151. The side surface of the trench T can be formed of the first bank 151, and the lower surface of the trench T can be formed of the second planarization layer 140.

The first electrode 210 can extend on the second planarization layer 140 exposed by the first and second banks 151 and 152 to the inside of the trench T. Referring to FIG. 6, the first electrode 210 can cover the entire one side surface of the trench T and can extend to a part of the lower surface of the trench T. For example, the first electrode 210 can extend to a part of the upper surface of the second planarization layer 140 exposed by the trench T.

Compared with the first embodiment of FIG. 4, the second embodiment of FIG. 6 discloses a structure in which the depth of the trench T is increased and the first electrode 210 is further extended. Therefore, it is possible to further prevent the outgas generated in the first bank 151 from penetrating into the boundary area between the first electrode 210 and the light emitting layer 220.

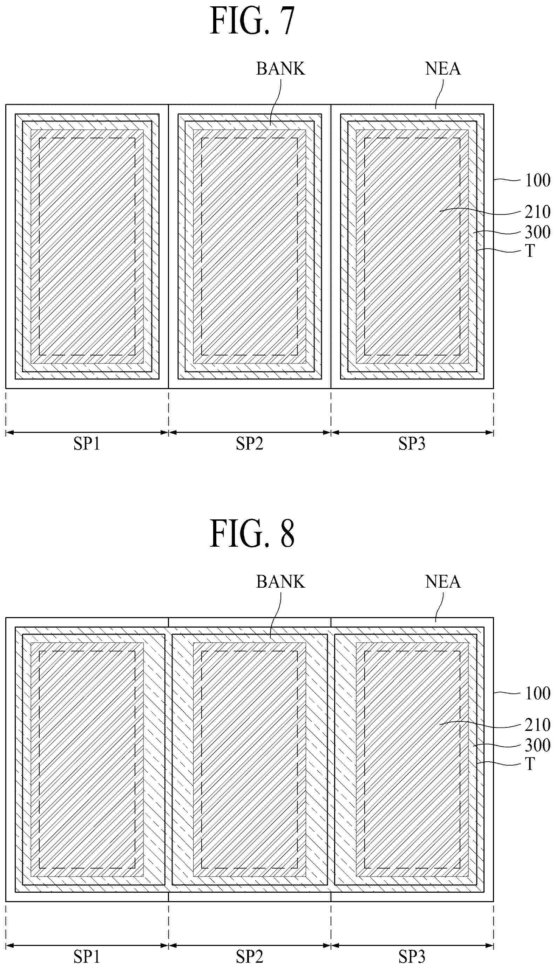

FIG. 7 is a plan view of one pixel of a display device according to another embodiment of the present disclosure. The display device can include pixels P, each having the configuration of FIG. 7.

Compared with FIGS. 2 and 3, FIG. 7 discloses substantially the same structure except for the structures of the first electrode 210 and the protective layer 300. Accordingly, the same reference numerals are used for the components that are the same as those of the pixels shown in FIGS. 2 and 3, and repeated descriptions are omitted or briefly provided.

Referring to FIG. 7, a bank BANK can be disposed on the substrate 100. Also, the bank BANK can include a trench T surrounding each of the emitting areas EA of the first to third sub-pixels SP1 to SP3.

The first electrode 210 can be disposed in each of the first to third sub-pixels SP1 to SP3. In one sub-pixel SP, the first electrode 210 can be disposed in the emitting area EA. In this case, the first electrode 210 can extend from the emitting area EA and can also be disposed in a part of the non-emitting area NEA. Specifically, in one sub-pixel SP, the first electrode 210 can be disposed in the non-emitting area NEA between the emitting area EA and the trench T. For example, the first electrode 210 can be disposed in an area surrounded by the trench T. Also, the first electrode 210 can be spaced apart from the trench T. For example, the first electrode 210 may not overlap the trench T.

The protective layer 300 is disposed in each of the first to third sub-pixels SP1 to SP3, and can be disposed on the same layer as the first electrode 210. The protective layer 300 can be in contact with the edge of the first electrode 210 and surround the first electrode 210. Also, the protective layer 300 can be disposed in the non-emitting area NEA. In detail, the protective layer 300 can be disposed in the non-emitting area NEA between the edge of the first electrode 210 and the trench T. For example, the protective layer 300 can be disposed in the area surrounded by the trench T. Also, the protective layer 300 can overlap the trench T.

The protective layer 300 can be formed of an inorganic insulating material such as silicon oxide (SiOx), silicon nitride (SiNx), silicon oxynitride (SiOxNy), etc. Also, the protective layer 300 can further include a material that absorbs moisture.

FIG. 8 is a plan view of one pixel of a display device according to another embodiment of the present disclosure. The display device can include pixels P, each having the configuration of FIG. 8.

Compared with FIG. 7, FIG. 8 discloses substantially the same structure except for the structures of the trench T and the protective layer 300. Accordingly, the same reference numerals are used for the same components as those of the pixel shown in FIG. 7, and repeated descriptions are omitted or briefly provided.

FIG. 7 illustrates that the trenches T are disposed in each of the first to third sub-pixels SP1 to SP3, but FIG. 8 illustrates that the trenches T are disposed in the boundary area of the first and second sub-pixels SP1 and SP2 and the boundary area of the second and third sub-pixels SP2 and SP3. For example, one trench can be disposed between the first and second sub-pixels SP1 and SP2, and one trench can be disposed between the second and third sub-pixels SP2 and SP3.

As described above in FIG. 7, the protective layer 300 can be disposed in each of the first to third sub-pixels SP1 to SP3, and can be disposed on the same layer as the first electrode 210. The protective layer 300 can contact the edge of the first electrode 210 and surround the first electrode 210. Also, the protective layer 300 can be disposed in the non-emitting area NEA. In detail, the protective layer 300 can be disposed in the non-emitting area NEA between the edge of the first electrode 210 and the trench T. For example, the protective layer 300 can be disposed in the area surrounded by the trench T. Also, the protective layer 300 can overlap the trench T.

In FIG. 8, since the trench T is disposed in the boundary area of the first and second sub-pixels SP1 and SP2 and the boundary area of the second and third sub-pixels SP2 and SP3, the protective layer 300 can also be disposed in the boundary area of the first and second sub-pixels SP1 and SP2 and the boundary area of the second and third sub-pixels SP2 and SP3.

For example, the protective layer 300 of the first sub-pixels SP1 and the protective layer 300 of the second sub-pixels SP2 are disposed in an area between the first electrode 210 of the first sub-pixel SP1 and the first electrode 210 of the second sub-pixel SP2, and can be in contact with each other. Also, the protective layer 300 of the second sub-pixels SP2 and the protective layer 300 of the third sub-pixels SP3 are disposed in an area between the first electrode 210 of the second sub-pixel SP2 and the first electrode 210 of the third sub-pixel SP3, and can be in contact with each other. Accordingly, the protective layer 300 of the first to third sub-pixels SP1 to SP3 can be consecutively formed without being spaced apart from each other.

The protective layer 300 can be formed of an inorganic insulating material such as silicon oxide (SiOx), silicon nitride (SiNx), silicon oxynitride (SiOxNy), etc. Also, the protective layer 300 can further include the material that absorbs moisture.

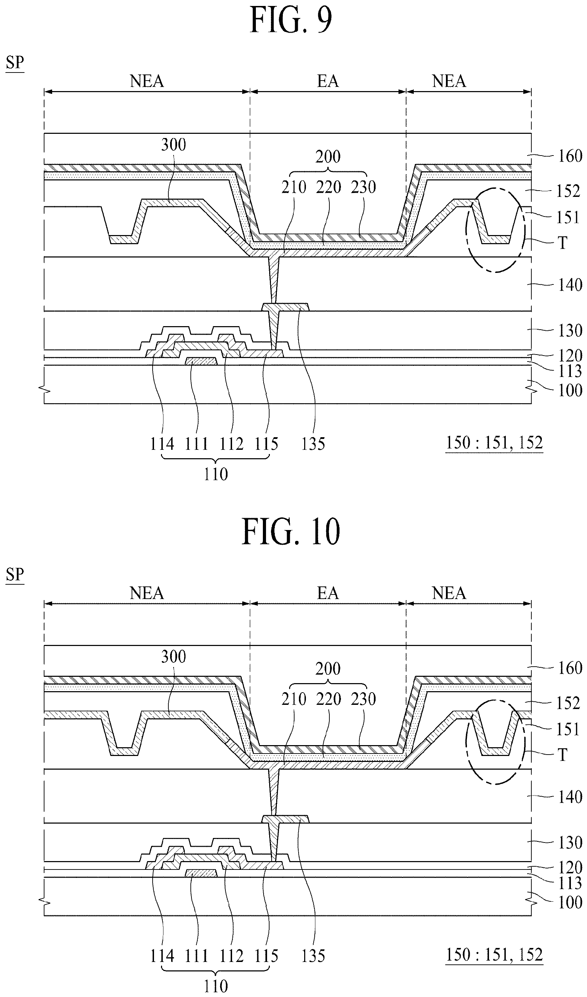

FIG. 9 is a cross-sectional view of a sub-pixel SP of a display device according to a third embodiment of the present disclosure. The display device can include sub-pixels SP, each having the configuration of FIG. 9. A cross-sectional view of any one of a plurality of sub-pixels shown in FIG. 7 is shown.

Compared with FIG. 4, FIG. 9 discloses substantially the same structure except for the structures of the first electrode 210 and the protective layer 300. Accordingly, the same reference numerals are used for the components that are the same as those of the sub-pixel SP shown in FIG. 4, and repeated descriptions are omitted or briefly provided.

Like FIG. 4, FIG. 9 discloses the trench T disposed in a first bank 151. The trench T can be formed by etching a partial region of the first bank 151. The depth of the trench T can be less than a distance between the flat upper and lower surfaces of the first bank 151. For example, the trench T may not expose the second planarization layer 140 disposed on the lower surface of the first bank 151. The side and lower surfaces of the trench T can be formed of a first bank 151.

The first electrode 210 can extend on the second planarization layer 140 exposed by the first and second banks 151 and 152 and can also be disposed on the upper surface of the first bank 151. For example, the first electrode 210 can be disposed in the emitting area EA and the non-emitting area NEA. In detail, an area of the first electrode 210 corresponding to the emitting area EA can be disposed on the upper surface of the second planarization layer 140, and an area of the first electrode 210 corresponding to the non-emitting area NEA can be disposed between the first and second banks 151 and 152.

The first electrode 210 can be disposed on the side surface of the first bank 151. For example, the end of the first electrode 210 can be disposed on the side surface of the first bank 151, but is not limited thereto. For example, the end of the first electrode 210 can extend to a flat upper surface of the first bank 151. Also, the first electrode 210 may not be disposed in the trench T.

The protective layer 300 can be disposed on the first bank 151. For example, the protective layer 300 can be disposed on the same layer as the first electrode 210. The protective layer 300 can be in contact with the end of the first electrode 210. As shown in FIG. 9, when the end of the first electrode 210 is disposed on the side surface of the first bank 151, a boundary area between the first electrode 210 and the protective layer 300 can be disposed on the side surface of the first bank 151.

The protective layer 300 can extend from the side surface of the first bank 151 to the inside of the trench T. For example, referring to FIG. 9, the protective layer 300 can cover the entire one side surface of the trench T and can extend to a part of the lower surface of the trench T, but is not limited thereto. For example, referring to a fifth embodiment of FIG. 10, the protective layer 300 can cover the entire upper surface of the first bank 151 exposed by the first electrode 210. For example, the protective layer 300 can cover both side surfaces and the entire lower surface of the trench T.

The protective layer 300 can be formed of an inorganic insulating material such as silicon oxide (SiOx), silicon nitride (SiNx), silicon oxynitride (SiOxNy), etc. Also, the protective layer 300 can further include the material that absorbs moisture.

In conclusion, the third and fourth embodiments of the present disclosure disclose a structure in which the first electrode 210 and the protective layer 300 are disposed between the first and second banks 151 and 152, and the protective layer 300 extends to the inside of the trench T of the first bank 151.

Since the protective layer 300 is formed of an inorganic insulating material that is resistant to moisture, it is possible to preferentially prevent the outgas generated in the first bank 151 from being directed to the first electrode 210. Also, since the protective layer 300 includes the material that absorbs moisture, an amount of outgas generated can be reduced. Therefore, it is possible to further prevent the outgas generated in the first bank 151 from penetrating into the boundary area between the first electrode 210 and the light emitting layer 220.

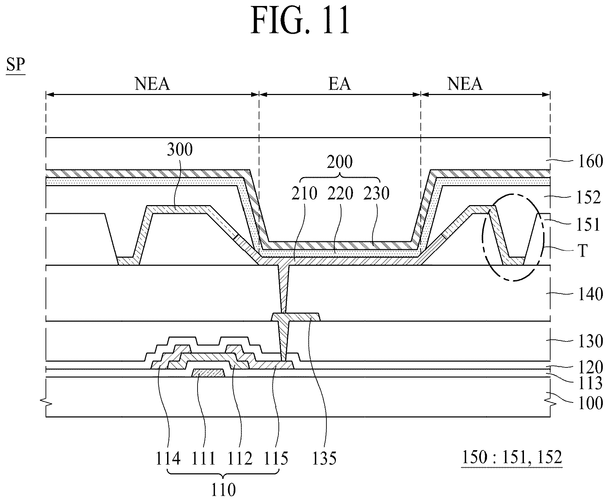

FIG. 11 is a cross-sectional view of a sub-pixel SP of a display device according to a fifth embodiment of the present disclosure. The display device can include sub-pixels SP, each having the configuration of FIG. 11.

As compared with FIG. 9, FIG. 11 discloses substantially the same structure except for the structures of the trench T and the protective layer 300. Accordingly, the same reference numerals are used for components that are the same as those of the sub-pixel SP shown in FIG. 9, and repeated descriptions are omitted or briefly provided.

Like FIG. 9, FIG. 11 discloses a trench T disposed in a first bank 151. In this case, FIG. 9 discloses a structure in which the first bank 151 covers the second planarization layer 140 below the trench T, but FIG. 11 discloses a structure in which the trench T exposes a part of the second planarization layer 140. For example, the depth of the trench T can be the same as the distance between the flat upper and lower surfaces of the first bank 151. The side surface of the trench T can be formed of the first bank 151, and the lower surface of the trench T can be formed of the second planarization layer 140.

The protective layer 300 can extend from the side surface of the first bank 151 to the inside of the trench T. Referring to FIG. 11, the protective layer 300 can cover the entire one side surface of the trench T and can extend to a part of the lower surface of the trench T. For example, the protective layer 300 can extend to a part of the upper surface of the second planarization layer 140 exposed by the trench T.

Compared with the third embodiment of FIG. 9, the fifth embodiment of FIG. 11 discloses a structure in which the depth of the trench T is increased and the length of the protective layer 300 is further extended. Therefore, the outgas generated in the first bank 151 can be further prevented from being directed to the first electrode 210. Also, the outgas generated in the first bank 151 can be further prevented from penetrating into the boundary area between the first electrode 210 and the light emitting layer 220.

According to one or more embodiments of the present disclosure, the following advantageous effects can be obtained.

According to one or more embodiments of the present disclosure, a damage to a light emitting device caused by an outgas may be prevented.

It will be apparent to those skilled in the art that the present disclosure described above is not limited by the above-described embodiments and the accompanying drawings and that various substitutions, modifications and variations can be made in the present disclosure without departing from the scope of the disclosures. Consequently, the scope of the present disclosure is defined by the accompanying claims and it is intended that all variations or modifications derived from the meaning, scope and equivalent concept of the claims fall within the scope of the present disclosure.

## Claims

1. A display device comprising:
a substrate (100) on which a plurality of sub-pixels (SP) are disposed, the plurality of sub-pixels (SP) including an emitting area (EA) and a non-emitting area (NEA) surrounding or adjacent to the emitting area (EA);
a planarization layer (140) disposed in the emitting area (EA) and the non-emitting area (NEA);
a first bank (151) disposed on the planarization layer (140) in the non-emitting area (NEA);
a first electrode (210) disposed on the planarization layer (140) in the emitting area (EA); and
a second bank (152) disposed on the first bank (151), wherein a trench (T) is disposed in an upper surface of the first bank (151), and
wherein the first electrode (210) extends to the upper surface of the first bank (151) and is disposed in the trench (T).

2. The display device of claim 1, wherein the first electrode (210) covers a part of one side surface of the trench (T) or the first electrode (210) covers the entire one side surface of the trench (T) and extends to a lower surface of the trench (T).

3. The display device of claim 1 or 2, wherein the first electrode (210) is disposed between the first and second banks (151, 152) in the non-emitting area (NEA) and/or the trench (T) exposes a part of an upper surface of the planarization layer (140).

4. A display device comprising:
a substrate (110) on which a plurality of sub-pixels (SP) are disposed, the plurality of sub-pixels (SP) including an emitting area (EA) and a non-emitting area (NEA) surrounding or adjacent to the emitting area (EA);
a planarization layer (140) disposed in the emitting area (EA) and the non-emitting area (NEA);
a first bank (151) disposed on the planarization layer (140) in the non-emitting area (NEA);
a first electrode (210) disposed on the planarization layer (140) in the emitting area (EA);
a protective layer (300) disposed on the first bank (151); and
a second bank (152) disposed on the protective layer, wherein a trench (T) is disposed in an upper surface of the first bank (151) and the protective layer (300) is disposed in the trench (T).

5. The display device of claim 4, wherein the first bank (151) exposes an upper surface of the planarization layer (140) corresponding to the emitting area (EA), and
the first electrode (210) extends to an upper surface of the first bank (151) from the upper surface of the planarization layer (140) corresponding to the emitting area (EA).

6. The display device of claim 4 or 5, wherein an end of the first electrode (210) is in contact with an end of the protective layer (300) on the upper surface of the first bank (151) or the first electrode (210) covers a partial area of the upper surface of the first bank (151, and the protective layer (300) covers a remaining area of the upper surface of the first bank (151).

7. The display device of claim 4, 5 or 6, wherein the protective layer (300) covers a part of one side surface of the trench (T) or the protective layer (300) covers an entire one side surface of the trench (T) and extends to a lower surface of the trench (T).

8. A display device comprising:
a substrate (100) on which a plurality of sub-pixels (SP) are disposed, the plurality of sub-pixels (SP) including an emitting area (EA) and a non-emitting area (NEA) surrounding or adjacent to the emitting area (EA);
a bank (150) disposed in the non-emitting area (NEA); and
a first electrode (210) disposed in the emitting area (EA),
wherein the bank (150) includes a trench (T) surrounding the emitting area (EA) of each of the plurality of sub-pixels (SP).

9. The display device of claim 8, wherein the plurality of sub-pixels (SP) include a first sub-pixel (SP1) and a second sub-pixel (SP2) adjacent to each other, and the trench (T) disposed in the first sub-pixel (SP1) is spaced apart from the trench (T) disposed in the second sub-pixel (SP2) or
the trench (T) is disposed in a boundary area between the first and second sub-pixels (SP1, SP2) .

10. The display device of claim 8 or 9, wherein the first electrode (210) extends to the non-emitting area (NEA) between the emitting area (EA) and the trench (T) from the emitting area (EA) and/or the first electrode (210) overlaps the trench (T).

11. The display device of claim 8, 9 or 10, further comprising a protective layer (300) surrounding the first electrode (210), and wherein the protective layer (300) is in contact with an edge of the first electrode (210), preferably the protective layer (300) is disposed in the non-emitting area (NEA) between the edge of the first electrode (210) and the trench (T), and overlaps the trench (T).

12. The display device of claim 9, 10 or 11, further comprising a protective layer (300) disposed in a boundary area between the first and second sub-pixels (SP1, SP2), wherein the protective layer (300) overlaps the trench (T).

13. The display device of claim 8, 9, 10, 11 or 12, wherein the bank (150) is a black bank.

14. The display device of any one of the preceding claims 4-13, wherein the protective layer (300) includes an inorganic insulating material and/or the protective layer (300) further includes a material that absorbs moisture.
